(19) **Europäisches Patentamt / European Patent Office / Office européen des brevets**

(11) **EP 2 957 031 B1**

(12) # FASCICULE DE BREVET EUROPEEN

(45) Date de publication et mention de la délivrance du brevet:
**19.07.2017 Bulletin 2017/29**

(21) Numéro de dépôt: **14711544.8**

(22) Date de dépôt: **13.02.2014**

(51) Int Cl.:
*H03H 9/02* *(2006.01)*          *H03H 9/24* *(2006.01)*
*H03H 9/205* *(2006.01)*          *H03H 9/15* *(2006.01)*

(86) Numéro de dépôt international:
**PCT/FR2014/000037**

(87) Numéro de publication internationale:
**WO 2014/125178 (21.08.2014 Gazette 2014/34)**

(54) **STRUCTURE PLANE DE RÉSONATEUR MÉCANIQUE DÉCOUPLÉ PAR DES VIBRATIONS DE FLEXION ET D'EXTENSION-COMPRESSION**

FLACHE STRUKTUR EINES MECHANISCHEN RESONATORS WELCHER DURCH BIEGE- UND DEHNUNGSSCHWINGUNGEN ENTKOPPELT IST

FLAT STRUCTURE OF A MECHANICAL RESONATOR DECOUPLED BY FLEXURAL AND EXTENSIONAL VIBRATIONS

(84) Etats contractants désignés:
**AL AT BE BG CH CY CZ DE DK EE ES FI FR GB GR HR HU IE IS IT LI LT LU LV MC MK MT NL NO PL PT RO RS SE SI SK SM TR**

(30) Priorité: **14.02.2013 FR 1300322**

(43) Date de publication de la demande:
**23.12.2015 Bulletin 2015/52**

(73) Titulaire: **Office National d'Etudes et de Recherches Aérospatiales (ONERA) 91120 Palaiseau (FR)**

(72) Inventeurs:
• **LE TRAON, Olivier**
  **F-91430 Vauhallan (FR)**
• **JANIAUD, Denis**
  **F-91940 Les Ulis (FR)**
• **TAIBI, Rachid**
  **F-91440 Bures-sur-Yvette (FR)**

• **CHARTIER, Claude**
  **F-91300 Massy (FR)**
• **GAUDINEAU, Vincent**
  **F-91120 Palaiseau (FR)**
• **PERNICE, Marc**
  **F-94260 Fresnes (FR)**

(74) Mandataire: **de Kernier, Gabriel Cabinet Netter Conseils en Propriété Industrielle 36, avenue Hoche 75008 Paris (FR)**

(56) Documents cités:
**US-A- 5 627 425**

• **LE TRAON O ET AL: "The fairy world of quartz vibrating MEMS", EUROPEAN FREQUENCY AND TIME FORUM (EFTF), 2012, IEEE, 23 avril 2012 (2012-04-23), pages 214-220, XP032369007, DOI: 10.1109/EFTF.2012.6502370 ISBN: 978-1-4673-1924-9**

EP 2 957 031 B1

**Description**

Le domaine technique de l'invention est celui des résonateurs mécaniques permettant de réaliser des instruments de mesure du temps ou de la fréquence. Plus particulièrement, l'invention concerne un résonateur mécanique à grand coefficient de qualité destiné par exemple à des horloges de haute stabilité appelées « Oscillateurs Ultra Stables » (OUS).

Le problème technique à résoudre est de réduire l'encombrement et le coût de fabrication du résonateur.

Avant de présenter l'état de l'art, il est utile de préciser ci-après la notion de coefficient de qualité d'un résonateur mécanique.

Dans les OUS, le résonateur mécanique est associé à une boucle électronique oscillatrice qui permet d'entretenir la vibration du résonateur à sa fréquence de résonance mécanique. Ainsi, la stabilité de la fréquence du signal électrique alternatif présent dans la boucle électronique bénéficie de la stabilité de la fréquence de la résonance mécanique du résonateur, généralement beaucoup plus grande que celle d'une boucle oscillatrice purement électronique.

La stabilité de la fréquence de résonance du résonateur mécanique est d'autant plus grande que le coefficient de qualité de la vibration de résonance est élevé, autrement dit que l'énergie de vibration contenue dans le résonateur est grande vis-à-vis de l'énergie perdue par période de la vibration. Il existe deux types de pertes d'énergie, d'une part les pertes intrinsèques dues par exemple à l'amortissement visqueux du matériau constituant le résonateur, d'autre part les pertes extrinsèques dues par exemple à un amortissement gazeux ou à une fixation inadaptée du résonateur. C'est pour cela que les meilleurs résonateurs sont réalisés dans des matériaux de très faible amortissement visqueux tels le quartz, qu'ils sont conditionnés sous vide dans un boîtier, et qu'ils sont fixés dans ce boîtier à l'emplacement de ce qu'il est convenu d'appeler idéalement un noeud de vibration.

Il existe une formulation pratique pour exprimer la contribution des différentes sources de pertes d'énergie, ainsi qu'il est expliqué dans ce qui suit.

L'expression du coefficient de qualité réel du résonateur s'écrit :

$$\mathrm{Q\ réel\ =\ 2\pi.E/\Delta E}$$

Où E est l'énergie contenue dans le résonateur et $\Delta E$ l'énergie perdue par période de la vibration. Pour les exemples précédemment cités, $\Delta E$ peut s'écrire :

$$\Delta E\ =\ \Delta E\ \mathrm{intrinsèque}\ +\ \Delta E\ \mathrm{gaz}\ +\ \Delta E\ \mathrm{fixation}$$

On peut donc écrire :

$$1/\mathrm{Q\ réel\ =\ (\Delta E\ intrinsèque\ +\ \Delta E\ gaz\ +\ \Delta E\ fixation)/2\pi.E}$$

Soit :

$$1/\mathrm{Q\ réel\ =\ \Delta E\ intrinsèque/2\pi.E\ +\ \Delta E\ gaz/2\pi.E\ +}$$
$$\Delta E\ \mathrm{fixation}/2\pi.E$$

Ainsi, on peut associer à chaque source de pertes d'énergie un facteur de qualité qui lui est propre, et écrire :

$$1/\mathrm{Q\ réel\ =\ 1/Q\ intrinsèque\ +\ 1/Q\ gaz\ +\ 1/Q\ fixation}$$

Pour que le coefficient de qualité réel du résonateur soit proche de son coefficient de qualité intrinsèque, il faut donc que les coefficients de qualité associés aux différentes sources de pertes extrinsèques soient très supérieurs au coefficient de qualité intrinsèque. A titre d'exemple, si Q intrinsèque est de l'ordre de $10^6$, il est souhaitable que Q fixation et Q gaz soient de l'ordre d'au moins $10^7$.

L'invention concerne les pertes dues à la fixation du résonateur, et vise à obtenir que Q fixation soit très supérieur à Q intrinsèque, tout en bénéficiant d'un encombrement et d'un coût de fabrication très faible.

L'état de l'art le plus proche regroupe les deux approches suivantes. Pour la première approche, de même que pour l'invention, la vibration du résonateur est un mode d'extension-compression. Pour la seconde approche, la vibration du résonateur est un mode de contour, ce qui signifie que la structure de la partie vibrante du résonateur est plane et que les vibrations s'effectuent principalement parallèlement à son plan ; il peut s'agir par exemple de vibrations d'extension-compression, de cisaillement ou de flexion.

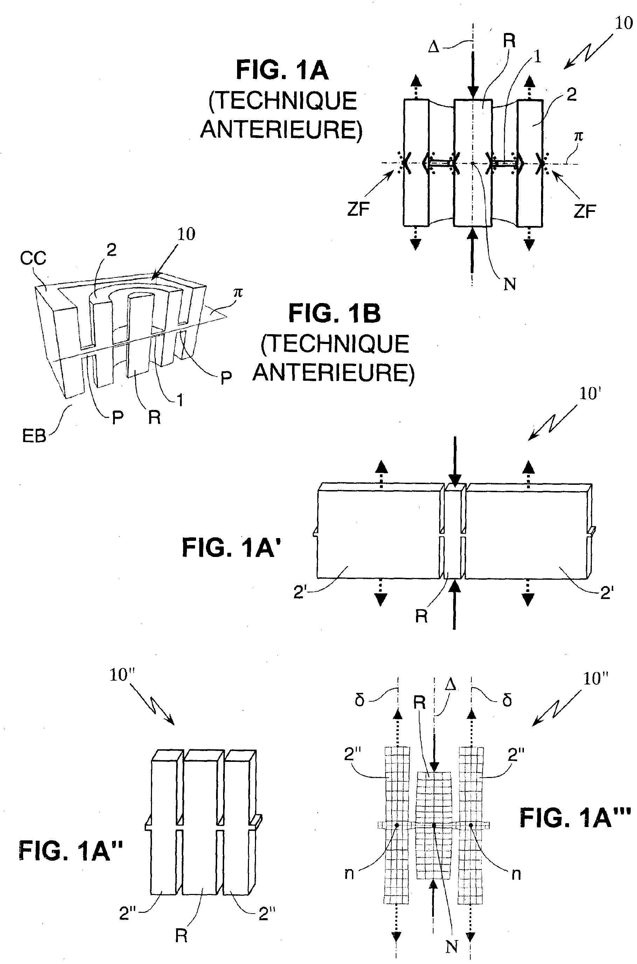

La première approche (**demande de brevet n°** FR 2 962 614 publiée le 13 janvier 2012 au nom du demandeur) est illustrée à la **figure 1A** destinée à expliquer le fonctionnement du coeur vibrant 10 du résonateur, et à la **figure 1B** qui montre une vue en perspective et en coupe longitudinale du résonateur comportant le coeur vibrant 10 et un cylindre droit creux CC de directrices carrées entourant le coeur vibrant 10 et destiné à être assemblé sur une embase de boîtier EB.

En se référant à la **figure 1A**, le coeur vibrant 10 du résonateur comporte un cylindre droit plein R, un cylindre droit creux 2 de même hauteur entourant le cylindre droit plein, et une membrane 1 disposée dans le plan médian n et solidaire de la surface cylindrique du cylindre plein et de la surface cylindrique intérieure du cylindre creux.

Le cylindre plein R vibre selon un mode de résonance d'extension-compression longitudinale et présente un nceud N de vibration situé dans le plan médian $\pi$, et le cylindre creux 2 vibre également en mode de résonance d'éxtension-compression longitudinale, à la même fréquence que le cylindre plein, mais en opposition de phase avec la vibration du cylindre plein. L'identité des fréquences de résonance des deux cylindres provient de l'identité de leurs hauteurs, qui est une condition nécessaire au fonctionnement du résonateur (cf page 9 ligne 37 à page 10 ligne 11 du brevet précité). Les vibrations en opposition de phase des deux cylindres correspondent à un mode de résonance mécanique particulier du coeur vibrant 10, c'est-à-dire à un mode spontané.

La masse du cylindre creux 2 est très supérieure à la masse du cylindre plein R, car l'épaisseur de la paroi du cylindre creux est de l'ordre de grandeur du diamètre du cylindre plein (cf page 12 ligne 2 à ligne 9). Cette condition géométrique implique en effet que la masse du cylindre creux 2 est de l'ordre de 10 fois la masse du cylindre plein R.

Il en découle que l'amplitude de vibration du cylindre creux est très inférieure à celle du cylindre plein, afin que s'équilibrent naturellement les quantités de mouvement mises en jeu dans ledit mode de résonance particulier (cf page 10 ligne 14 à ligne 22). Cela permet que les effets des déformations radiales (effets de Poisson) des deux cylindres se compensent dans une zone ZF située sur la surface extérieure du cylindre creux au voisinage du plan médian $\pi$.

Ainsi, la zone ZF peut être quasiment découplée de la vibration du résonateur, ce qui permet, comme montré à la **figure 1B**, de tenir le cylindre creux 2 au moyen de ponts P solidaires d'un cylindre creux CC sans altérer le coefficient de qualité intrinsèque du résonateur. Le fonctionnement de ce résonateur connu de la technique antérieure est ainsi très satisfaisant.

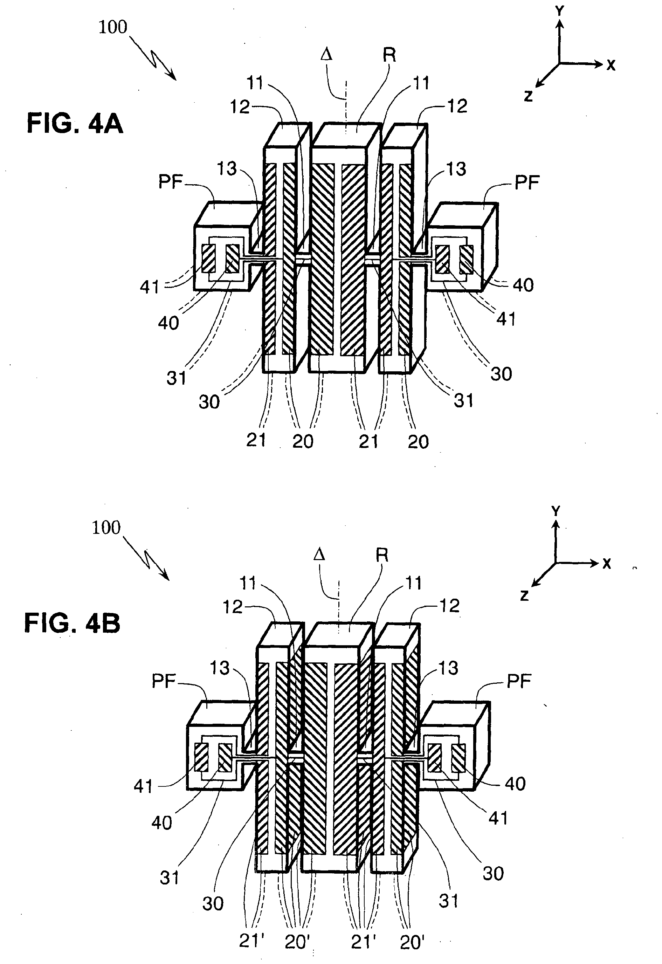

L'enseignement de la première approche est par ailleurs complété dans l'article intitulé "A Micro-Resonator for Fundamental Physics Experiments an its Possible Interest for Time and Frequency Applications" de Olivier Le Traon (European Frequency and Time Forum, 2011) qui indique que l'extension-compression du cylindre creux s'accompagne d'une courbure de sa paroi (figure 4 de l'article et dernière ligne du paragraphe II), laissant ainsi entendre que le comportement réel du coeur vibrant du résonateur est un peu plus complexe que le principe de base présenté dans le brevet précité.

**Les inconvénients de cette première approche** résident en premier lieu dans l'encombrement du résonateur dû à sa structure tridimensionnelle mal adaptée aux techniques d'intégration de micro systèmes dont les structures sont généralement planes ; en second lieu, le bon fonctionnement du résonateur est exigeant sur la symétrie du résonateur par rapport au plan médian $\pi$, particulièrement sur la position de la membrane 1 obtenue en contrôlant la profondeur des usinages effectués parallèlement à l'axe longitudinal $\Delta$ du résonateur, ce qui grève le coût de fabrication.

**Il pourrait paraître intéressant de s'inspirer de cette première approche** en tentant de faire fonctionner une structure plane de coeur vibrant sur un mode similaire à celui décrit dans la première approche, ainsi qu'illustré à la **figure 1A'** qui montre ladite structure plane référencée 10' comportant un barreau R et deux poutres 2' disposées de part et d'autre du barreau.

Afin de respecter les conditions préconisées par le brevet précité, les poutres 2' devraient avoir la même hauteur que celle du barreau et une masse très supérieure à celle du barreau, ce qui conduirait pour les poutres 2' à une très grande dimension prise dans le plan de la structure perpendiculairement à leur dimension de hauteur, ainsi qu'il est illustré à la figure 1A'.

Ainsi, cette nouvelle approche, bien que bénéficiant de l'avantage d'une structure plane, présenterait comme la première approche l'inconvénient d'un encombrement important.

**Il pourrait également paraître intéressant de s'inspirer seulement de la figure 1A de la première approche,** sans respecter la condition préconisée d'un rapport de masses important entre les poutres et le barreau. Cela conduirait à tenter de faire fonctionner une structure plane 10" de coeur vibrant telle qu'illustrée à la figure 1A". Une étude effectuée au moyen de simulations numériques (éléments finis) montre que généralement cette nouvelle approche ne fonctionne pas. Ainsi qu'illustré à la figure 1A''', chacune des poutres 2" vibre en résonance d'extension-compression en opposition de phase avec la résonance d'extension-compression du barreau R, mais les effets de Poisson des poutres ne compensent pas ceux du barreau. Plus précisément, les effets de Poisson des poutres ont des amplitudes voisines de celles des effets de Poisson du barreau, mais sont de sens opposé aux effets de Poisson du barreau ; en d'autres termes, les effets de Poisson des poutres "accompagnent" les effets de Poisson du barreau. De ce fait, l'axe central longitudinal δ de chacune des poutres reste pratiquement immobile au cours de la vibration. Dans ces conditions, la symétrie de chacune des poutres et de sa vibration conduit, de la même manière que pour le barreau, à l'existence d'un noeud n de vibration situé au centre de la poutre, c'est-à-dire au coeur de la matière. De ce fait, le coeur vibrant ne présente pas de zone permettant de le tenir sans altérer le coefficient de qualité intrinsèque du résonateur.

La seconde approche de l'état de l'art le plus proche est montrée dans le brevet US n° 4,350,918 publié le 21 septembre 1982 au nom de Kabushiki Kaisha Daini Seikosha et illustrée aux figures 2A, 2B et 2C et 2D (figures 8, 9, 10bet 10c du brevet).

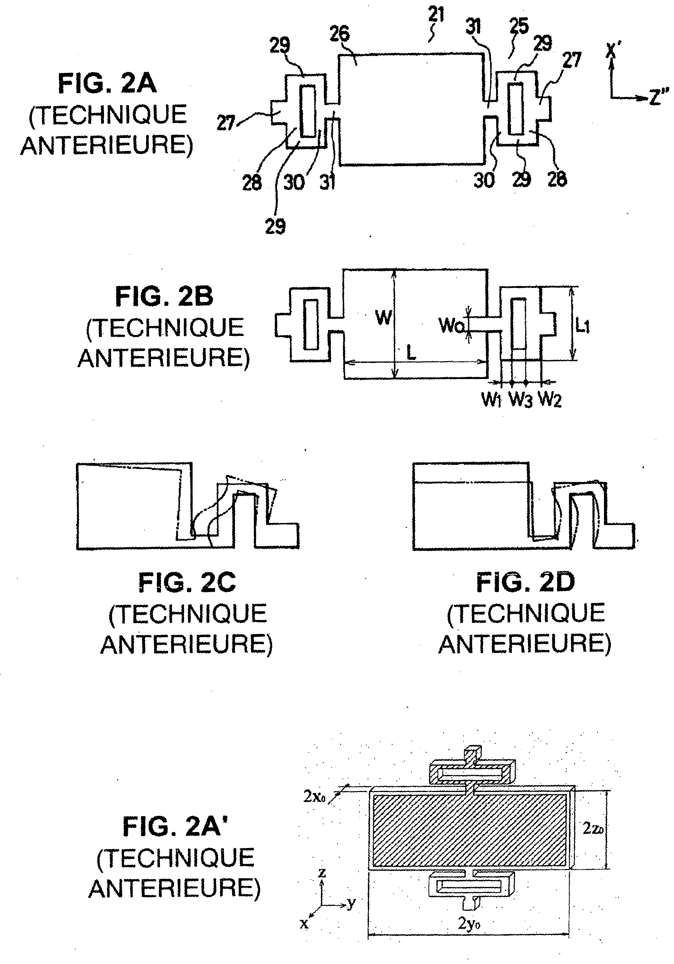

La **figure 2A** montre une vue de face d'un résonateur piézoélectrique 21 à mode de vibration de contour comprenant une portion vibrante 26 et au moins une portion support 25 faisant une pièce avec la portion vibrante par le moyen d'une partie en pont 31. Le résonateur 21 est caractérisé en ce que chaque portion support 25 consiste en une partie élastique 30 interconnectée avec ladite portion vibrante 26, une partie d'atténuation 28 faite d'une pièce avec ladite partie élastique 30 et ne se déplaçant que d'une façon minime et une partie de fixation 27 destinée à être fixée à une pièce support.

La partie d'atténuation 28 est connectée par ses deux extrémités à la partie élastique 30 par l'intermédiaire de parties de connexion 29, formant ainsi une lumière dans la portion support 25.

La largeur de la partie en pont 31, la largeur de la partie élastique 30, la largeur de la partie d'atténuation 28, la distance entre la partie élastique et la partie d'atténuation, et la longueur de la partie élastique sont respectivement W0, W1, W2, W3 et L1, comme le montre la **figure 2B.**

Ces dimensions jouent un rôle important dans le fonctionnement de ce résonateur, en particulier dans le découplage des vibrations de la portion vibrante 26 vis-à-vis de la partie de fixation 27. Lorsque que ces dimensions satisfont un certain nombre de relations précisées dans le brevet précité, alors le découplage peut être excellent ainsi qu'illustré aux figures 2C et 2D qui montrent seulement un quart de la figure 2A tenant compte de la symétrie.

Les **figures 2C et 2D** montrent en trait pointillé les déformations exagérément agrandies du résonateur vibrant sur deux modes de contour respectivement. On précise que le résonateur est prévu pour fonctionner simultanément sur ces deux modes volontairement couplés entre eux, ce qui est obtenu en respectant certains rapports dimensionnels entre le côté court W et le côté long L de la portion vibrante 26 ; cela permet d'obtenir une excellente caractéristique fréquence/température du résonateur.

Pour obtenir le découplage des vibrations de la portion vibrante 26 vis-à-vis de la partie de fixation 27, il est donc nécessaire que chacun des deux modes de contour illustrés aux figures 2C et 2D soit découplé de ladite partie de fixation. C'est ce qui est obtenu au moyen de cette seconde approche, car le déplacement de la partie de fixation 27 est minime pour les deux modes.

L'enseignement de la seconde approche est par ailleurs complété dans l'article intitulé **"Design and Fabrication of Lenght-Extensional Mode Rectangular X-Cut Quartz Resonator with Zero Temperature Coefficient"** de Yukio Yokoyama (IEEE Transactions on Ultrasonics, Ferroelectrics, and Frequency Control, vol. 53, no. 5, may 2006) qui présente un résonateur apte à vibrer selon un mode d'extension-compression longitudinale et illustré à la **figure 2A'** (figure 9 de l'article).

Bien que l'article soit très peu explicite sur le fonctionnement de ce résonateur (quelques lignes à la fin de la conclusion), l'homme du métier peut reconnaître le dispositif de la seconde approche illustré à la figure 2A, et comprendre que l'auteur de l'article a adapté la seconde approche au cas particulier d'un résonateur vibrant sur un seul mode de contour, en l'occurrence le mode d'extension-compression longitudinale.

Les structures planes des résonateurs de la seconde approche et leurs usinages exclusivement débouchants sont bien adaptés aux techniques d'intégration de micro systèmes.

Par contre, **l'inconvénient de cette seconde approche** concerne la difficulté de réaliser le résonateur avec une précision suffisante pour assurer un bon fonctionnement, notamment au niveau des portions supports 25 et plus précisément en ce qui concerne les largeurs W1 et W2 de la partie élastique et de la partie d'atténuation respectivement, ainsi que la distance W3 entre la partie élastique et la partie d'atténuation. Cette difficulté de réalisation, d'autant plus grande que les dimensions du résonateur sont petites, se traduit soit par un frein à la miniaturisation du résonateur, soit par un coût de fabrication relativement élevé.

**L'invention** a notamment pour but de surmonter les inconvénients des approches antérieures en proposant un résonateur mécanique dont le fonctionnement est aussi satisfaisant que celui procuré par les première et seconde approches, mais dont la structure est mieux adaptée à la réduction de l'encombrement et du coût du résonateur.

Pour bien comprendre les éléments caractérisant l'invention, il est utile de rappeler que l'élancement d'une poutre parallélépipédique, pris dans un plan porté par sa dimension de longueur L et l'une de ses deux dimensions de section c, est défini par le rapport L/c.

Afin de surmonter les inconvénients des approches antérieures, la structure plane de résonateur mécanique comportant un barreau vibrant selon un mode de résonance d'extension-compression suivant son axe central longitudinal et présentant un noeud de vibration dans son plan médian perpendiculaire audit axe central longitudinal, la vibration induisant naturellement des déformations transverses d'extension-compression, est **caractérisée** en ce que la structure comporte deux poutres parallélépipédiques sensiblement identiques entre elles, symétriques chacune par rapport audit plan médian et disposées respectivement de part et d'autre du barreau, les axes longitudinaux des poutres étant parallèles audit axe central longitudinal, la longueur des poutres étant sensiblement égale à celle du barreau et l'élancement des poutres pris dans le plan de la structure étant sensiblement égal au résultat de l'addition de six et demi et d'un nombre valant vingt-huit pour-cent de l'élancement du barreau pris dans le plan de la structure, et deux éléments de liaison disposés respectivement de part et d'autre du barreau au voisinage dudit plan médian et reliant chacun une face du barreau à une face d'une poutre, ce grâce à quoi les poutres, excitées au niveau des éléments de liaison par lesdites déformations transverses d'extension-compression du barreau, vibrent chacune simultanément selon deux modes, le premier mode étant un mode d'extension-compression longitudinale en opposition de phase avec la vibration du barreau, le second mode étant un mode de flexion s'effectuant parallèlement au plan de la structure, et les effets des déformations transverses du barreau et de chacune des poutres se compensent dans une zone située sur la face de la poutre opposée à la face solidaire de l'élément de liaison et au voisinage dudit plan médian.

Les vibrations simultanées du barreau en mode de résonance d'extension-compression longitudinale et des poutres selon lesdits premier et second modes correspondent à un mode de résonance mécanique particulier de la structure de résonateur selon l'invention, pour lequel la mise en vibration peut être spontanément obtenue en excitant le barreau en mode de résonance d'extension-compression longitudinale.

Les deux relations dimensionnelles indiquées ci-dessus entre les poutres et le barreau sont nécessaires au bon fonctionnement du résonateur selon l'invention, car en premier lieu elles permettent la coexistence desdits premier et second modes de vibration des poutres : la première relation (longueur des poutres sensiblement égale à celle du barreau) concerne le premier mode et permet de faire travailler les poutres sensiblement à leur fréquence de résonance en extension-compression longitudinale ; en addition à la première relation, la seconde relation (élancement des poutres sensiblement égal au résultat de l'addition de six et demi et d'un nombre valant vingt-huit pour-cent de l'élancement du barreau) concerne le second mode et permet de faire travailler les poutres au voisinage de leur fréquence de résonance en flexion.

En second lieu, les deux relations dimensionnelles conditionnent la répartition des déformations transverses de chacune des poutres provenant d'une part dudit premier mode d'extension-compression longitudinale et d'autre part dudit second mode de flexion, de telle sorte que les effets de la déformation transverse globale de la poutre compensent les effets des déformations transverses du barreau dans ladite zone.

Ainsi, pour un barreau de longueur et d'élancement donnés, la longueur et l'élancement des poutres permettant cette compensation ont chacun une valeur unique.

A titre d'illustration, si la première relation est satisfaite mais que la seconde ne l'est pas, alors les effets des déformations transverses provenant dudit second mode de flexion ne sont pas ajustés pour obtenir la compensation des effets des déformations transverses du barreau et de chacune des poutres dans ladite zone, et le résonateur ne fonctionne pas ; c'est le cas notamment du coeur vibrant inspiré de la première approche et montré aux figures 1A" et 1A"': la longueur des poutres égale à celle du barreau permet l'existence dudit premier mode d'extension-compression longitudinale, mais l'élancement des poutres, voisin de cinq, est trop éloigné de celui préconisé par la seconde relation (élancement nécessairement supérieur à six et demi) pour permettre l'existence dudit second mode de flexion.

De même, le résonateur ne fonctionne pas si la seconde relation est satisfaite mais pas la première, car dans ce cas il n'y a pas de mise en vibration dudit premier mode d'extension-compression longitudinale des poutres.

Lorsque les deux relations dimensionnelles sont satisfaites, ladite zone située sur la face de chacune des poutres opposée à la face solidaire de l'élément de liaison peut être découplée de la vibration du barreau et il est possible, en fixant le dispositif sur ladite zone, d'obtenir que le coefficient de qualité réel du barreau soit voisin de son grand coefficient de qualité intrinsèque. Afin d'obtenir le découplage maximal, le dimensionnement du résonateur est optimisé par exemple au moyen de simulations numériques basées sur la méthode des éléments finis.

De plus, le résonateur peut être réalisé à très faible coût par usinage collectif exclusivement débouchant d'une plaque plane de matériau d'épaisseur uniforme.

Par rapport à la configuration relativement complexe des portions supports (25) de la seconde approche montrée à la figure 2A (chaque portion support comporte une partie élastique, une partie d'atténuation et deux parties de connexion), la configuration massive des poutres du résonateur selon l'invention permet que le bon fonctionnement du résonateur soit moins exigeant en ce qui concerne la précision de réalisation. De ce fait, la structure de résonateur selon l'invention est plus facile à réaliser, donc plus favorable à la réduction du coût et de l'encombrement du résonateur.

Selon un deuxième mode particulier de réalisation, la structure comporte en outre deux pavés de fixation disposés vers l'extérieur de la structure et reliés chacun à une poutre au moyen d'un élément de liaison disposé au voisinage dudit plan médian, c'est-à-dire dans ladite zone, ce qui permet que la fixation desdits pavés sur un support n'altère pas le coefficient de qualité du résonateur.

Selon un troisième mode particulier de réalisation, la structure est en quartz, le plan de la structure étant parallèle au plan cristallographique XY et l'axe central longitudinal du barreau étant parallèle à l'axe cristallographique Y, et la structure est équipée de moyens de mise en vibration agissant par effet piézoélectrique.

Selon un quatrième mode particulier de réalisation, la structure plane de résonateur mécanique selon le troisième mode de réalisation est caractérisée en ce que les moyens de mise en vibration comportent des électrodes disposées sur des faces du barreau et des poutres et s'étendant parallèlement à l'axe central longitudinal.

Selon un cinquième mode particulier de réalisation, la structure plane de résonateur mécanique selon le quatrième mode de réalisation est caractérisée en ce que la structure est réalisée par gravure chimique dans des dimensions sub-millimétriques.

Selon un sixième mode particulier de réalisation, la structure plane de résonateur mécanique selon le quatrième mode de réalisation est caractérisée en ce que la structure est réalisée par gravure ionique réactive dans des dimensions sub-millimétriques.

Les caractéristiques et avantages de l'invention apparaîtront plus clairement à la lecture de la description détaillée et des figures qui s'y rapportent dans lesquelles :

- la figure 1A est destinée à expliquer le fonctionnement du coeur vibrant d'un résonateur selon la technique antérieure et déjà commenté ;
- la figure 1B est une vue en perspective et en coupe longitudinale dudit résonateur selon la technique antérieure et déjà commentée ;
- la figure 1A' est une vue en perspective d'un coeur vibrant dont le fonctionnement est inspiré de celui du coeur vibrant de la figure 1A et déjà commentée ;
- la figure 1A" est une vue en perspective d'un autre coeur vibrant dont le fonctionnement est inspiré de celui du coeur vibrant de la figure 1A et déjà commentée ;
- la figure 1A"' est destinée à expliquer le fonctionnement du coeur vibrant de la figure 1A" et déjà commentée ;
- les figures 2A et 2B sont des vues de face d'un autre résonateur selon la technique antérieure et déjà commentées ;
- les figures 2C et 2D montrent, sur seulement un quart du résonateur de la figure 2A, des déformations du résonateur vibrant sur deux modes de contour respectivement et déjà commentées ;
- la figure 2A' est une vue en perspective d'un autre résonateur selon la technique antérieure et déjà commentée ;

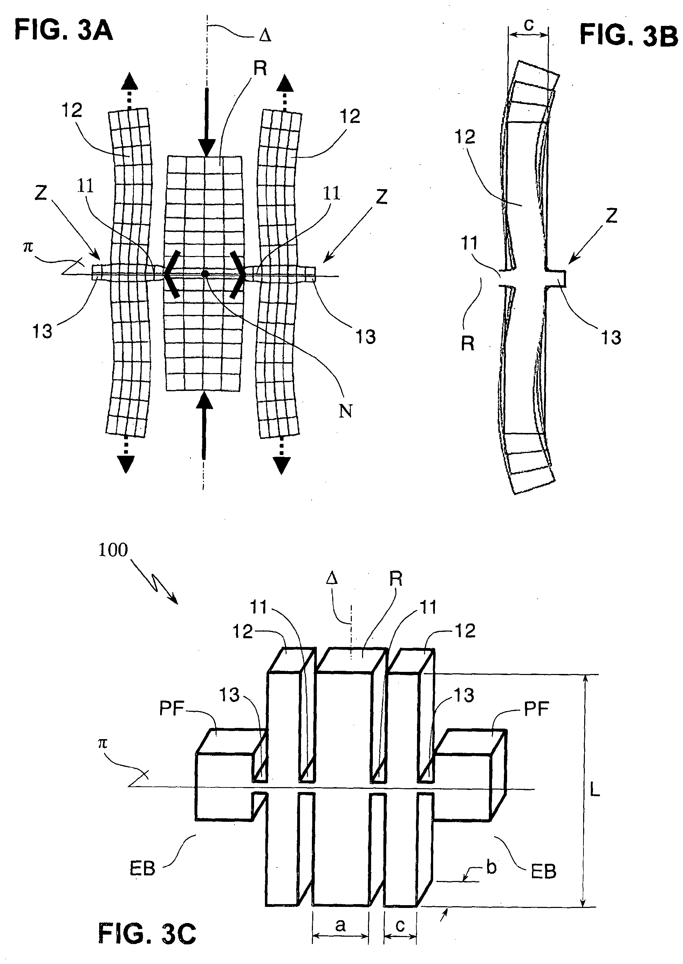

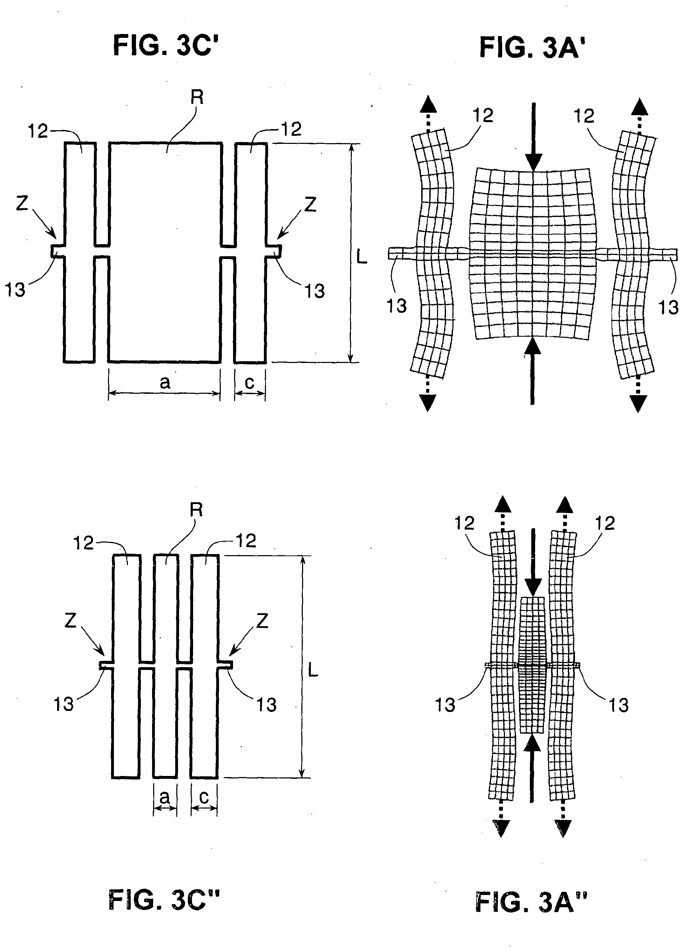

- les figures 3A et 3B sont destinées à expliquer le fonctionnement du coeur vibrant d'un résonateur selon l'invention ;
- la figure 3C est une vue en perspective d'un résonateur selon l'invention ;
- les figures 3A' et 3C' montrent des vues de face du coeur vibrant d'un autre résonateur selon l'invention, pour lequel l'élancement du barreau est plus petit que celui illustré aux figures 3A et 3C ;
- les figures 3A" et 3C" montrent des vues de face du coeur vibrant d'un autre résonateur selon l'invention, pour lequel l'élancement du barreau est plus grand que celui illustré aux figures 3A et 3C ; et
- les figures 4A et 4B montrent des électrodes permettant l'excitation par effet piézoélectrique de la vibration du résonateur de la figure 3C dans le cas où celui-ci est en quartz.

On se réfère d'abord à la **figure 3C** qui montre une vue en perspective d'un résonateur 100 selon l'invention. La structure du résonateur 100 est monolithique et réalisée dans une plaque plane de matériau d'épaisseur uniforme b au moyen d'un usinage exclusivement débouchant ; la structure est donc bien adaptée aux techniques d'intégration de micro systèmes. Le matériau est choisi avantageusement pour son très faible amortissement visqueux ; il peut s'agir par exemple d'un matériau isotrope comme la silice, ou d'un matériau cristallin comme le quartz. L'usinage peut être effectué par exemple par gravure ionique réactive ou par gravure chimique.

Le résonateur 100 comporte un barreau R parallélépipédique dont l'axe central longitudinal Δ s'étend parallèlement au plan de la plaque et dont le plan médian n perpendiculaire audit axe central longitudinal Δ est donc perpendiculaire au plan de la plaque.

Les dimensions du barreau R prises dans le plan de la plaque sont sa longueur L et sa largeur a ; l'élancement du barreau R pris dans le plan de la plaque vaut donc L/a. Sur la représentation illustrée, ledit élancement du barreau est sensiblement égal à 4.

Le résonateur 100 comporte également deux poutres 12 parallélépipédiques sensiblement identiques entre elles, symétriques chacune par rapport au plan médian n et disposées respectivement de part et d'autre du barreau, les axes longitudinaux des poutres étant parallèles à l'axe central longitudinal Δ, la longueur des poutres étant sensiblement égale à la longueur L du barreau et leur largeur c étant telle que l'élancement L/c des poutres pris dans le plan de la plaque vaut sensiblement le résultat de l'addition de 6,5 et d'un nombre valant 28% de l'élancement L/a du barreau ; en l'occurrence, l'élancement des poutres vaut sensiblement :

$$L/c = 6,5 + 0,28 \times 4 = 7,62$$

Concernant la dimension d'épaisseur b de la plaque, le résonateur selon l'invention n'impose pas de recommandation précise. Il faut simplement veiller à ce que l'épaisseur b ne soit pas trop faible (ce qui pourrait induire des modes de vibrations parasites transverses à la plaque) ou trop forte (des effets de Poisson transverses à la plaque pourraient contrarier le bon fonctionnement du résonateur). Dans la pratique, le résonateur selon l'invention s'accommode bien d'une épaisseur b de la plaque de l'ordre de grandeur de la largeur c des poutres.

Le résonateur 100 comporte également deux éléments de liaison 11 disposés respectivement de part et d'autre du barreau au voisinage dudit plan médian et reliant chacun une face usinée du barreau à une face usinée d'une poutre.

Le résonateur 100 comporte également deux pavés de fixation PF disposés vers l'extérieur du résonateur et reliés chacun à une poutre 12 au moyen d'un élément de liaison 13 disposé au voisinage du plan médian $\pi$. Les pavés de fixation PF sont destinés à être assemblés sur une embase de boîtier EB (non représentée).

Le fonctionnement du résonateur selon l'invention est maintenant expliqué en relation avec les figures 3A et 3B issues de simulations numériques par éléments finis et qui illustrent le comportement du coeur vibrant du résonateur 100.

Il est important de souligner que, pour ces simulations numériques, le coeur vibrant du résonateur est dissocié des pavés de fixation et qu'il n'est pas fixé, c'est-à-dire qu'il est totalement libre de se déplacer (on dit qu'il est "tenu par les anges").

**La figure 3A** montre des déformations exagérément agrandies du barreau R vibrant selon un mode de résonance d'extension-compression suivant son axe central longitudinal $\Delta$ et présentant un noeud de vibration N dans son plan médian $\pi$, la vibration induisant naturellement des déformations transverses d'extension-compression dues au coefficient de Poisson du matériau et indiquées sur la figure à l'aide de flèches en forme de V, lesdites déformations transverses étant maximales dans le plan médian $\pi$ et nulles aux extrémités du barreau. On notera que le barreau R montré à la figure 3A et sa vibration d'extension-compression longitudinale induisant naturellement des déformations transverses sont analogues au cylindre droit plein R de la technique antérieure montré à la figure 1A et à sa vibration.

Toujours en se référant à la figure 3A, les poutres 12 vibrent chacune simultanément selon deux modes, le premier mode étant un mode d'extension-compression longitudinale en opposition de phase avec la vibration du barreau, le second mode étant un mode de flexion (deuxième partiel) s'effectuant parallèlement au plan de la plaque, l'excitation mécanique des poutres s'effectuant au niveau des éléments de liaison 11.

Il est important de souligner que les vibrations simultanées du barreau en mode de résonance d'extension-compression longitudinale et des poutres selon lesdits premier et second modes correspondent à un mode de résonance mécanique particulier du résonateur selon l'invention, pour lequel la mise en vibration peut être spontanément obtenue en excitant le barreau en mode de résonance d'extension-compression longitudinale, par exemple en équipant le barreau de moyens de mise en vibration ainsi qu'il sera expliqué plus loin.

Les deux relations dimensionnelles expliquées précédemment entre les poutres et le barreau permettent en premier lieu la coexistence desdits premier et second modes : la première relation (longueur des poutres sensiblement égale à celle du barreau) concerne le premier mode et permet de faire travailler les poutres sensiblement à leur fréquence de résonance en extension-compression longitudinale ; en addition à la première relation, la seconde relation (élancement des poutres sensiblement égal au résultat de l'addition de six et demi et d'un nombre valant vingt-huit pour-cent de l'élancement du barreau) concerne le second mode et permet de faire travailler les poutres au voisinage de leur fréquence de résonance en flexion ; en l'occurrence, dans le cas du résonateur montré à la figure 3C pour lequel l'élancement du barreau est sensiblement égal à 4, la fréquence de résonance en flexion des poutres est supérieure d'environ 10% à la fréquence du résonateur.

En second lieu, les deux relations dimensionnelles conditionnent la répartition des déformations transverses de chacune des poutres provenant d'une part dudit premier mode d'extension-compression longitudinale et d'autre part dudit second mode de flexion, de telle sorte que les effets de la déformation transverse globale de la poutre compensent les effets des déformations transverses du barreau dans une zone Z située sur la face de la poutre opposée à la face solidaire de l'élément de liaison 11 et au voisinage du plan médian $\pi$, ainsi qu'il est expliqué dans ce qui suit en relation avec la figure 3B.

**La figure 3B** montre la superposition de différents états de la déformation exagérément agrandie d'une poutre 12 au cours de la demi période de la vibration du résonateur correspondant à la compression longitudinale du barreau.

On voit que la poutre se déforme simultanément en extension (ledit premier mode) et en flexion (ledit second mode), et que sa dimension de largeur, initialement c, subit une variation alternative au cours de la vibration, ladite variation alternative étant maximale au voisinage du plan médian $\pi$ et nulle aux extrémités de la poutre ; ladite variation alternative résulte de la combinaison de deux phénomènes.

Le premier phénomène est la déformation transverse de la poutre (effet de Poisson) liée à son extension longitudinale.

Le second phénomène est la déformation transverse de la poutre liée à sa flexion et à son excitation mécanique par l'élément de liaison 11.

Toujours sur la figure 3B, on voit également que cela se traduit par un déplacement de l'élément de liaison 11 en phase avec la déformation transverse d'extension-compression du barreau, et que l'élément de liaison 13 situé dans la zone Z ne subit pratiquement pas de déplacement au cours de la vibration ; cela est dû au fait que la répartition des déformations transverses de chacune des poutres provenant d'une part dudit premier mode et d'autre part dudit second mode est telle que les effets de la déformation transverse globale de la poutre compensent les effets des déformations transverses du barreau dans la zone Z, c'est-à-dire au niveau de l'élément de liaison 13, ce qui résulte d'un dimensionnement de la poutre tel que sa longueur est sensiblement égale à celle du barreau et que son élancement est sensiblement égal au résultat de l'addition de six et demi et d'un nombre valant vingt-huit pour-cent de l'élancement du barreau.

L'homme du métier comprendra que l'explication qui vient d'être donnée en référence à la figure 3B pour la demi période de la vibration du résonateur correspondant à la compression longitudinale du barreau est similaire pour l'autre demi période qui correspond à l'extension longitudinale du barreau, la seule différence portant sur le sens du déplacement de l'élément de liaison 11.

Afin d'obtenir le mieux possible cette immobilité spontanée de l'élément de liaison 13 au cours de la vibration du coeur vibrant du résonateur, le dimensionnement de la poutre est optimisé par exemple au moyen de simulations numériques par éléments finis. Bien entendu, ce qui vient d'être montré pour une poutre en relation avec la figure 3B vaut également pour l'autre poutre.

Ainsi, les éléments de liaison 13 situés dans les zones Z peuvent être complètement découplés de la vibration du barreau, et il est possible, en fixant le coeur vibrant du résonateur au niveau desdits éléments de liaison par exemple au moyen des pavés de fixation PF montrés à la figure 3C, d'obtenir que le coefficient de qualité réel du barreau soit voisin de son grand coefficient de qualité intrinsèque.

Le bon fonctionnement du résonateur selon l'invention est moins exigeant sur la précision de réalisation que le résonateur selon la seconde approche illustré aux figures 2A et 2B. Cela est dû au fait que, à taille égale de résonateur, les portions supports du résonateur selon la seconde approche comportent des éléments de relativement petites dimensions (en particulier les épaisseurs W1 et W3 de la partie élastique 30 et de la partie d'atténuation 28), ce qui n'est pas le cas des poutres massives du résonateur selon l'invention.

Ainsi, la structure du résonateur selon l'invention est mieux adaptée à la réduction de l'encombrement et du coût du résonateur.

En ce qui concerne la forme des poutres 12 du résonateur selon l'invention, l'homme du métier comprendra que l'expression "poutre parallélépipédique", telle qu'utilisée ici, est à considérer au sens large, l'important étant que le fonctionnement du résonateur soit similaire à celui qui vient d'être décrit. Par exemple, le contour de face des poutres, rectangulaire sur les figures illustrant l'invention, peut présenter des chanfreins ou des arrondis en remplacement des angles vifs. Ceci n'est pas un inconvénient pour le fonctionnement du résonateur selon l'invention si l'on a soin de prendre en compte ces formes dans les simulations numériques servant à l'optimisation du fonctionnement du résonateur.

Il vient d'être expliqué le fonctionnement mécanique du coeur vibrant d'un résonateur selon l'invention, dimensionné pour un barreau d'élancement L/a sensiblement égal à 4.

Il va maintenant être montré que le fonctionnement est similaire pour un coeur vibrant dimensionné pour un barreau d'élancement plus petit (figures 3A' et 3C') ou plus grand (figures 3A" et 3C").

La **figure 3C'** montre une vue de face du coeur vibrant d'un autre résonateur selon l'invention, pour lequel l'élancement L/a du barreau R est sensiblement égal à 2.

La longueur des poutres 12 est sensiblement égale à la longueur L du barreau et leur largeur c est telle que l'élancement L/c des poutres vaut sensiblement le résultat de l'addition de 6,5 et d'un nombre valant 28% de l'élancement L/a du barreau ; en l'occurrence, l'élancement des poutres vaut sensiblement :

$$\mathrm{L/c} = 6{,}5 + 0{,}28 \ \times \ 2 = 7{,}06$$

Sur la **figure 3A'** qui montre des déformations exagérément agrandies de ce coeur vibrant, on voit que les poutres 12 vibrent chacune simultanément selon lesdits premier et second modes, et les résultats des simulations numériques par éléments finis indiquent que les éléments de liaison 13 ne subissent pratiquement pas de déplacement au cours de la vibration.

La **figure 3C"** montre une vue de face du coeur vibrant d'un autre résonateur selon l'invention, pour lequel l'élancement L/a du barreau R est sensiblement égal à 10.

La longueur des poutres 12 est sensiblement égale à la longueur L du barreau et leur largeur c est telle que l'élancement L/c des poutres vaut sensiblement le résultat de l'addition de 6,5 et d'un nombre valant 28% de l'élancement L/a du barreau ; en l'occurrence, l'élancement des poutres vaut sensiblement :

$$L/c = 6,5 + 0,28 \times 10 = 9,3$$

Sur la **figure 3A"** qui montre des déformations exagérément agrandies de ce coeur vibrant, on voit que les poutres 12 vibrent chacune simultanément selon lesdits premier et second modes, et les résultats des simulations numériques par éléments finis indiquent que les éléments de liaison 13 ne subissent pratiquement pas de déplacement au cours de la vibration.

D'une façon générale, le résonateur selon l'invention convient à tout élancement de barreau.

Il est intéressant de noter que pour des élancements très différents de barreau, tels que l'élancement de valeur 2 montré à la figure 3C' et l'élancement de valeur 10 montré à la figure 3C", les élancements des poutres sont de valeurs relativement voisines, respectivement 7,06 et 9,3.

Cela est dû au fait que ledit second mode de flexion des poutres du résonateur selon l'invention est excité au voisinage de sa résonance, la fréquence d'excitation étant celle de la vibration de résonance d'extension-compression du barreau.

Or, pour un matériau donné, la fréquence de résonance d'extension-compression du barreau est sensiblement proportionnelle à la grandeur 1/L, et la fréquence de résonance de flexion des poutres est sensiblement proportionnelle à la grandeur $c/L^2$.

Ainsi, puisque ces deux fréquences sont voisines, le rapport desdites grandeurs est voisin d'une constante :

$$(1/L)/(c/L^2) = L/c = \text{élancement des poutres} \approx \text{constante}$$

Ainsi qu'expliqué précédemment, le résonateur selon l'invention est bien adapté à la miniaturisation.

A titre d'exemple, il est possible de réaliser un résonateur en quartz de dimensions hors tout 500 $\mu$m $\times$ 500 $\mu$m $\times$ 50 $\mu$m dont la fréquence est de l'ordre de 5 MHz et dont le coefficient de qualité est supérieur à $10^6$.

Il va maintenant être présenté, en référence aux figures 4A et 4B, des moyens de mise en vibration du résonateur dans le cas où celui-ci est en quartz dont l'orientation des axes cristallographiques X, Y, Z est indiquée sur les figures.

La **figure 4A** montre le résonateur 100 de la figure 3C dont le barreau R est équipé d'électrodes 20 et 21 agissant par effet piézoélectrique. Les électrodes 20 et 21 sont disposées sur chacune des deux faces du barreau R affleurant les grandes faces de la plaque, et sont sous la forme de rubans s'étendant parallèlement à l'axe longitudinal $\Delta$ qui est également l'axe cristallographique mécanique Y du quartz.

La figure 4A montre les électrodes 20 et 21 sur l'une desdites faces du barreau ; les électrodes 20 et 21 sur l'autre face, indiquées à l'aide d'un trait de référence en pointillé, sont respectivement disposées en regard.

Les électrodes 20 et 21 sont aptes à créer dans le barreau un champ électrique dont la composante $E_X$ perpendiculaire à l'axe longitudinal $\Delta$ et parallèle aux grandes faces de la plaque est couplée par effet piézoélectrique à la contrainte mécanique d'extension ou de compression $T_{YY}$ intervenant de façon prépondérante dans la vibration d'extension-compression du barreau R. Ainsi, les électrodes 20 et 21 sont des moyens efficaces de mise en vibration du barreau R.

Toujours en relation avec la figure 4A, les poutres 12 du résonateur 100 sont elles aussi équipées d'électrodes agissant par effet piézoélectrique et référencées elles aussi 20 et 21 pour traduire l'identité des polarités avec les électrodes du barreau R.

Ainsi qu'il est visible sur la figure, la disposition des électrodes des poutres 12 permet de créer dans les poutres un champ électrique dont la composante $E_X$ est opposée à celle du barreau. De cette façon, les électrodes 20 et 21 sont aptes à exciter dans les poutres une vibration d'extension-compression longitudinale en opposition de phase avec la vibration d'extension-compression longitudinale du barreau.

Il est important de noter que les électrodes 20 et 21 équipant les poutres ne sont pas nécessaires au fonctionnement du résonateur selon l'invention, car la mise en vibration du barreau suffit, mécaniquement, à mettre en vibration les poutres en opposition de phase comme expliqué précédemment. Néanmoins, les électrodes 20 et 21 équipant les poutres sont intéressantes car elles permettent d'améliorer le couplage piézoélectrique du résonateur.

Les électrodes 20 et 21 sont reliées à des plages de connexions électriques respectivement 40 et 41 disposées sur les pavés de fixation PF, au moyen de rubans de raccordement respectivement 30 et 31 courant sur les éléments de liaison 11 et 13, les poutres 12 et les pavés de fixation PF.

La **figure 4B** montre le résonateur 100 équipé d'électrodes 20' et 21' plus complètes que les électrodes 20 et 21 de la figure 4A. Les électrodes 20' et 21' comprennent, en plus des rubans disposés sur les faces du barreau et des poutres affleurant les deux grandes faces de la plaque, d'autres rubans disposés sur les faces usinées du barreau et des poutres et réalisés par exemple par évaporation de métal suivant des directions obliques par rapport aux axes principaux du résonateur, chacun desdits autres rubans étant en contact électrique avec le ruban d'une grande face affleurant l'arête commune.

Ainsi, la composante $E_X$ du champ électrique peut être plus intense, et l'efficacité des électrodes 20' et 21' plus grande que celle des électrodes 20 et 21, moyennant toutefois un surcoût de fabrication.

De plus, la liaison électrique entre les rubans des deux grandes faces étant assurée par lesdits autres rubans, il n'est plus nécessaire de disposer les rubans de raccordement 30 et 31 et les plages de connexion 40 et 41 sur les deux grandes faces du résonateur.

## Revendications

1. Structure plane de résonateur mécanique (100) comportant un barreau (R) vibrant selon un mode d'extension-compression suivant son axe central longitudinal ($\Delta$) et présentant un noeud de vibration (N) dans son plan médian ($\pi$) perpendiculaire audit axe central longitudinal, la vibration induisant naturellement des déformations transverses d'extension-compression,
   **caractérisée en ce que** la structure comporte deux poutres (12) parallélépipédiques sensiblement identiques entre elles, symétriques chacune par rapport audit plan médian (n) et disposées respectivement de part et d'autre du barreau (R), les axes longitudinaux des poutres étant parallèles audit axe central longitudinal ($\Delta$), la longueur des poutres étant sensiblement égale à la longueur (L) du barreau et l'élancement (L/c) des poutres pris dans le plan de la structure étant sensiblement égal au résultat de l'addition de six et demi et d'un nombre valant vingt-huit pour-cent de l'élancement (L/a) du barreau pris dans le plan de la structure, et deux éléments de liaison (11) disposés respectivement de part et d'autre du barreau au voisinage dudit plan médian et reliant chacun une face du barreau à une face d'une poutre, ce grâce à quoi les poutres, excitées au niveau des éléments de liaison (11) par lesdites déformations transverses d'extension-compression du barreau, vibrent chacune simultanément selon deux modes, le premier mode étant un mode d'extension-compression longitudinale en opposition de phase avec la vibration du barreau, le second mode étant un mode de flexion s'effectuant parallèlement au plan de la structure, et les effets des déformations transverses du barreau et de chacune des poutres se compensent dans une zone (Z) située sur la face de la poutre opposée à la face solidaire de l'élément de liaison (11) et au voisinage dudit plan médian (n).

2. Structure plane de résonateur mécanique selon la revendication 1, **caractérisée en ce que** la structure comporte en outre deux pavés de fixation (PF) disposés vers l'extérieur de la structure et reliés chacun à une poutre (12) au moyen d'un élément de liaison (13) disposé au voisinage du plan médian ($\pi$).

3. Structure plane de résonateur mécanique selon l'une quelconque des revendications précédentes, **caractérisée en ce que** la structure est en quartz, le plan de la structure étant parallèle au plan cristallographique XY et l'axe central longitudinal ($\Delta$) du barreau étant parallèle à l'axe cristallographique Y, et que la structure est équipée de moyens de mise en vibration agissant par effet piézoélectrique.

4. Structure plane de résonateur mécanique selon la revendication 3, **caractérisée en ce que** les moyens de mise en vibration comportent des électrodes (20, 21 ; 20', 21') disposées sur des faces du barreau et des poutres et s'étendant parallèlement à l'axe central longitudinal ($\Delta$).

5. Structure plane dé résonateur mécanique selon la revendication 4, **caractérisée en ce que** la structure est réalisée par gravure chimique dans des dimensions sub-millimétriques.

6. Structure plane de résonateur mécanique selon la revendication 4, **caractérisée en ce que** la structure est réalisée par gravure ionique réactive dans des dimensions sub-millimétriques.

## Patentansprüche

1. Flache Struktur eines mechanischen Resonators (100), der einen Stab (R) umfasst, der gemäß einer Dehnungs-/Kompressionsfunktionsart entlang seiner Längsmittelachse ($\Delta$) schwingt und einen Schwingungsknoten (N) in seiner Mittelebene (n) aufweist, die senkrecht zur Längsmittelachse ist, wobei die Schwingung auf natürliche Weise Dehnungs-/Kompressionsquerverformungen herbeiführt,
   **dadurch gekennzeichnet, dass** die Struktur zwei zueinander im Wesentlichen identische quaderförmige Balken (12) umfasst, die jeweils in Bezug auf die Mittelebene (π) symmetrisch und auf einer bzw. der anderen Seite des Stabs (R) angeordnet sind, wobei die Längsachsen der Balken zur Längsmittelachse (Δ) parallel sind, wobei die Länge der Balken im Wesentlichen gleich der Länge (L) des Stabs ist und das Längenverhältnis (L/c) der Balken in der Ebene der Struktur im Wesentlichen gleich dem Ergebnis der Addition von sechseinhalb und einer Zahl ist, die achtundzwanzig Prozent des Längenverhältnisses (L/a) des Stabs in der Ebene der Struktur beträgt, und zwei Verbindungelemente (11) umfasst, die auf der einen bzw. der anderen Seite des Stabs in der Nachbarschaft der Mittelebene angeordnet sind und jeweils eine Seite des Stabs mit einer Seite eines Balkens verbinden, wodurch die Balken, die im Bereich der Verbindungselemente (11) durch die Dehnungs-/Kompressionsquerverformungen des Balkens angeregt werden, jeweils gleichzeitig gemäß zweier Funktionsarten schwingen, wobei die erste Funktionsart eine Längsdehnungs-Längskompressionsfunktionsart in Gegenphase zur Schwingung des Balkens ist, wobei die zweite Funktionsart eine Durchbiegungsfunktionsart ist, die parallel zur Ebene der Struktur erfolgt, und sich die Auswirkungen der Querverformungen des Stabs und jeweils der Balken in einer Zone (Z) ausgleichen, die sich auf der Seite des Balkens, die der mit dem Verbindungselement (11) fest verbundenen Seite gegenüberliegt, und in der Nachbarschaft der Mittelebene (n) befindet.

2. Flache Struktur eines mechanischen Resonators nach Anspruch 1, **dadurch gekennzeichnet, dass** die Struktur darüber hinaus zwei Fixierungsblöcke (PF) umfasst, die zum Äußeren der Struktur hin angeordnet und jeweils mittels eines in der Nachbarschaft der Mittelebene (π) angeordneten Verbindungselements (13) mit einem Balken (12) verbunden sind.

3. Flache Struktur eines mechanischen Resonators nach einem der vorhergehenden Ansprüche, **dadurch gekennzeichnet, dass** die Struktur aus Quarz ist, wobei die Ebene der Struktur parallel zur kristallografischen Ebene XY ist, und wobei die Längsmittelachse (Δ) des Balkens parallel zur kristallografischen Ebene Y ist, und dass die Struktur mit Schwingungsbewirkungseinrichtungen ausgestattet ist, die durch piezoelektrischen Effekt wirken.

4. Flache Struktur eines mechanischen Resonators nach Anspruch 3, **dadurch gekennzeichnet, dass** die Schwingungsbewirkungseinrichtungen Elektroden (20, 21; 20', 21') umfassen, die an den Seiten des Balkens und der Stäbe vorgesehen sind und sich parallel zur Längsmittelachse (Δ) erstrecken.

5. Flache Struktur eines mechanischen Resonators nach Anspruch 4, **dadurch gekennzeichnet, dass** die Struktur durch chemisches Ätzen in Submillimeterabmessungen hergestellt ist.

6. Flache Struktur eines mechanischen Resonators nach Anspruch 4, **dadurch gekennzeichnet, dass** die Struktur durch reaktives Ionenätzen in Submillimeterabmessungen hergestellt ist.

**Claims**

1. A planar mechanical resonator structure (100) comprising a bar (R) vibrating according to an expansion-compression mode along its longitudinal central axis (Δ) and having a vibration node (N) in its median plane (n) at right angles to said longitudinal central axis, the vibration naturally inducing transverse expansion-compression deformations, **characterized in that** the structure comprises two parallelepipedal beams (12) that are substantially identical to one another, each symmetrical relative to said median plane (π) and positioned respectively on either side of the bar (R), the longitudinal axes of the beams being parallel to said longitudinal central axis (Δ), the length of the beams being substantially equal to the length (L) of the bar and the slenderness ratio (L/c) of the beams taken in the plane of the structure being substantially equal to the result of the addition of six and a half and a number equivalent to twenty eight percent of the slenderness ratio (L/a) of the bar taken in the plane of the structure, and two link elements (11) positioned respectively on either side of the bar in the vicinity of said median plane and each linking a face of the bar to a face of a beam, by virtue of which the beams, excited at the link elements (11) by said transverse expansion-compression deformations of the bar, each vibrate simultaneously according to two modes, the first mode being a longitudinal expansion-compression mode in phase opposition with the vibration of the bar, the second mode being a bending mode taking place parallel to the plane of the structure, and the effects of the transverse deformations of the bar and of each of the beams are neutralized in a zone (Z) situated on the face of the beam opposite the face secured to the link element (11) and in the vicinity of said median plane (π).

2. The planar mechanical resonator structure as claimed in claim 1, **characterized in that** the structure further comprises two fixing blocks (PF) positioned toward the outside of the structure and each linked to a beam (12) by means of a link element (13) positioned in the vicinity of the median plane (n).

3. The planar mechanical resonator structure as claimed in either one of the preceding claims, **characterized in that** the structure is made of quartz, the plane of the structure being parallel to the crystallographic plane XY and the longitudinal central axis ($\Delta$) of the bar being parallel to the crystallographic axis Y, and that the structure is equipped with vibrating means that act by piezoelectric effect.

4. The planar mechanical resonator structure as claimed in claim 3, **characterized in that** the vibrating means comprise electrodes (20, 21; 20', 21') positioned on faces of the bar and of the beams and extending parallel to the longitudinal central axis ($\Delta$).

5. The planar mechanical resonator structure as claimed in claim 4, **characterized in that** the structure is produced by chemical etching in sub-millimetric dimensions.

6. The planar mechanical resonator structure as claimed in claim 4, **characterized in that** the structure is produced by reactive ion etching in sub-millimetric dimensions.

**FIG. 1A**
(TECHNIQUE
ANTERIEURE)

**FIG. 1B**
(TECHNIQUE
ANTERIEURE)

**FIG. 1A'**

**FIG. 1A''**

**FIG. 1A'''**

**FIG. 2A**
(TECHNIQUE
ANTERIEURE)

**FIG. 2B**
(TECHNIQUE
ANTERIEURE)

**FIG. 2C**
(TECHNIQUE
ANTERIEURE)

**FIG. 2D**
(TECHNIQUE
ANTERIEURE)

**FIG. 2A'**
(TECHNIQUE
ANTERIEURE)

**FIG. 3A**

Δ

R

12    12

Z    Z

11    11

π

13    13

N

**FIG. 3B**

c

12

Z

11

R    13

**FIG. 3C**

100

Δ    R

11    11

12    12

13    13

PF    PF

π

L

EB    EB

b

a    c

## FIG. 3C'

## FIG. 3A'

## FIG. 3C"

## FIG. 3A"

FIG. 4A

FIG. 4B

## RÉFÉRENCES CITÉES DANS LA DESCRIPTION

**Documents brevets cités dans la description**

- FR 2962614

- US 4350918 A

**Littérature non-brevet citée dans la description**

- **YUKIO YOKOYAMA.** Design and Fabrication of Lenght-Extensional Mode Rectangular X-Cut Quartz Resonator with Zero Temperature Coefficient. *IEEE Transactions on Ultrasonics, Ferroelectrics, and Frequency Control,* Mai 2006, vol. 53 (5